# EUROPEAN PATENT APPLICATION

(11) **EP 2 511 967 A1**
(43) Date of publication of application: **17.10.2012**
(21) Application number: 10843115.6
(22) Date of filing: 18.11.2010
(51) Int. Cl.: H01L 33/64, F21S 2/00, F21V 29/00, G02F 1/1333, G02F 1/13357, F21Y 101/02

(54) **LED SUBSTRATE, BACKLIGHT UNIT, AND LIQUID CRYSTAL DISPLAY**

(30) Priority: 12.01.2010 JP 2010003839
(71) Applicant: Sharp Kabushiki Kaisha, Osaka-shi, Osaka 545-8522 (JP)
(72) Inventor: HOSOKI, Mitsuru, Osaka-shi, Osaka 545-8522 (JP)
(74) Representative: Müller-Boré & Partner Patentanwälte
(86) International application number: PCT/JP2010/070622
(87) International publication number: WO 2011/086760

(57) **Abstract**

Provided is an LED substrate capable of being downsized in width. In addition, provided are LED substrates that can be disposed laterally in an efficient fashion. Each LED substrate (20) includes a radiating plate (22) made from metal, an insulating layer (23), a connector (40) disposed in the middle of the LED substrate, a plurality of LEDs (21) disposed to the right and left of the connector, first and second ground patterns (34, 35) disposed at left and right ends of each LED substrate, and a third ground pattern (36) disposed in the middle of the LED substrate, wherein the first, second and third ground patterns are electrically connected to the metallic radiating plate, which is disposed under the first, second and third ground patterns while sandwiching therebetween the insulating layer, via sheet-metal screws (71, 72 and 73).

## Description

### Technical Field

The present invention relates to an LED substrate including a plurality of LEDs, a backlight unit including the LED substrate, and a liquid crystal display device including a liquid crystal display panel and the backlight unit that is disposed behind the liquid crystal display panel.

### Background Art

A liquid crystal display device including a transmissive liquid crystal display panel includes a backlight unit that is disposed behind the liquid crystal display panel to project light thereonto. A side (edge) backlight unit is known as this kind of backlight unit, which includes a light guide plate having a plate shape that is made from a transparent material such as an acrylate resin, and a light source that includes a cold cathode tube (fluorescent lamp) or an LED (Light-Emitting Diode) that is disposed along one side or more than one side of the light guide plate. The side backlight unit described above has an advantage such that a thin profile thereof can be easily achieved compared with a direct backlight unit including a light source disposed behind a liquid crystal display panel.

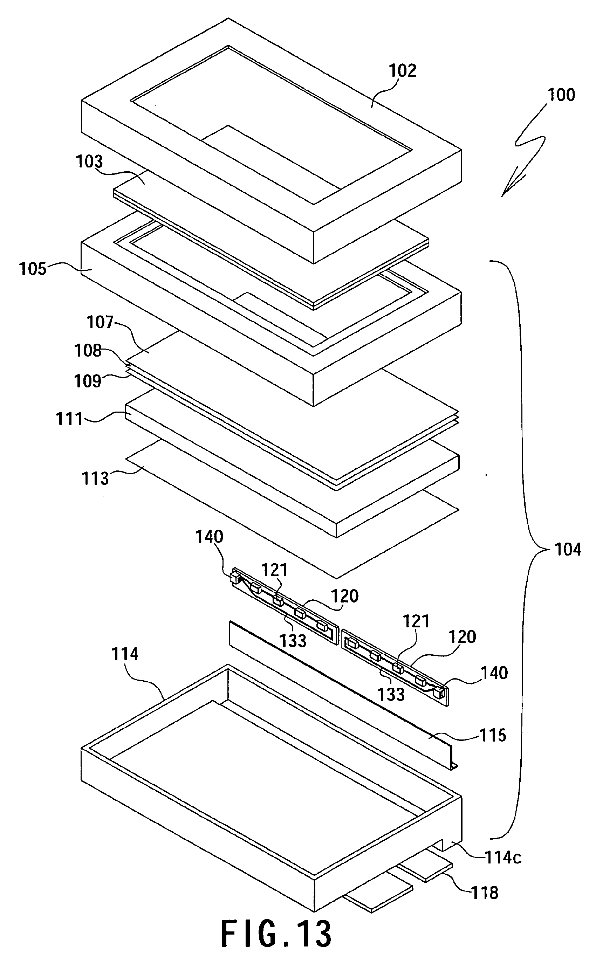

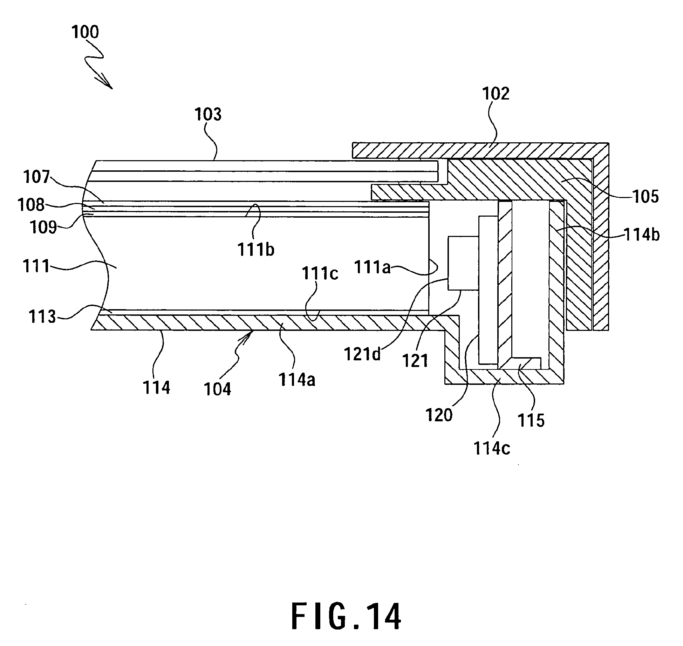

In particular, a liquid crystal display device that includes an LED as a light source of a side backlight unit has the advantages of long life and high luminous efficiency, and thus has been receiving attention. Fig. 13 is an exploded perspective view showing a schematic configuration of a liquid crystal display device including this kind of side backlight unit including LEDs. Fig. 14 is a cross-sectional view showing a relevant portion of the same.

As shown in Fig. 13, aliquidcrystaldisplaydevice 100 includes a bezel 102, a liquid crystal display panel 103, and a backlight unit 104.

The bezel 102 has a square frame shape with an opening so as to cover edge portions of the liquid crystal display panel 103, and is arranged to, together with a backlight chassis 114, ensure strength of the entire liquid crystal display device 100. The liquid crystal display panel 103 includes two glasses that are bonded together, and liquid crystals are filled in a space between the glasses. The liquid crystal display panel 103 is capable of displaying an image on its front face.

The backlight unit 104 includes the backlight chassis 114 having the shape of a box of low height. The chassis 114 houses optical sheets 107 to 109, a light guide plate 111, a reflection sheet 113, and two LED substrates 120.

As shown in Fig. 14, the light guide plate 111 includes a light incidence surface 111a arrange to obtain light from the LEDs 121 of the LED substrates 120, and a light emitting surface 111b arrange to emit the light upward (in a direction to project the light), which is obtained from the light incidence surface 111a. The light incidence surface 111a is defined by a given side surface of the light guide plate 111, and the light emitting surface 111b is defined by a front surface of the light guide plate 111.

The reflection sheet 113 is disposed so as to cover a back surface 111c of the light guide plate 111, which is the opposite surface to the light emitting surface 111b. The optical sheets 107 to 109 define optical sheets such as a diffusion sheet and a lens sheet, and are disposed above the light emitting surface 111b of the light guide plate 111.

The optical sheets 107 to 109, the light guide plate 111 and the reflection sheet 113 are stacked and fixed onto a bottom plate 114a of the backlight chassis 114 by a frame 105.

In addition, the LEDs 121 provided to the LED substrates 120 are disposed close to the light incidence surface 111a of the light guide plate 111. Further, light emitting surfaces 121d of the LEDs 121 are disposed along the light incidence surface 111a of the light guide plate 111 , having a given space therebetween so as to be opposed to the light incidence surface 111a. In this case, the two LED substrates 120 are fixed so as to be disposed laterally while standing on a fixing plate 115 having the shape of the letter "L" that is provided so as to stand on the bottom plate 114a in the vicinity of a side wall 114b of the backlight chassis 114.

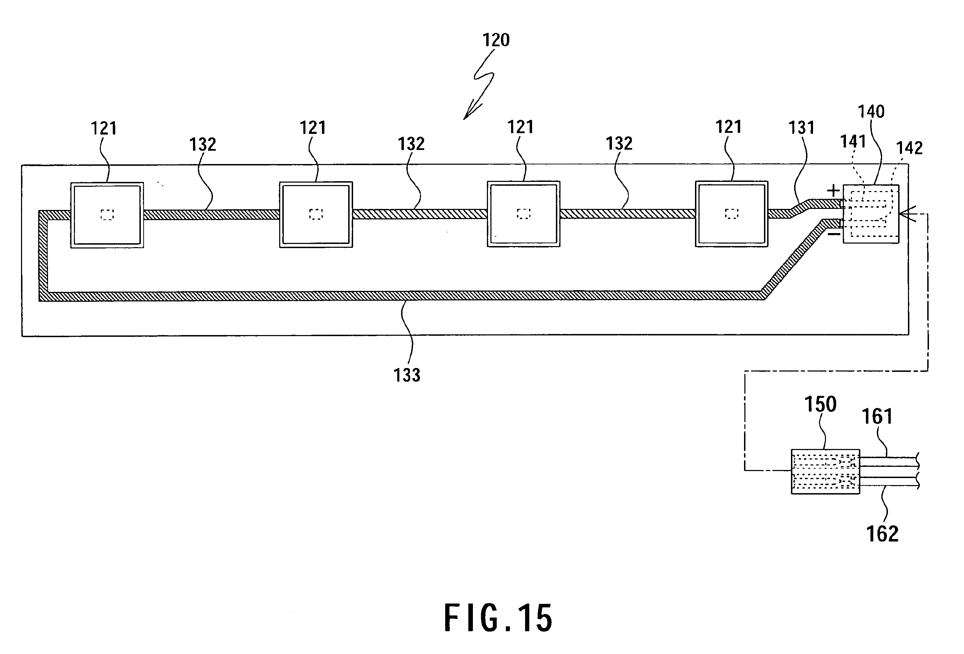

Each LED substrate 120 includes wiring patterns 131, 132 and 133 that are formed on a radiating plate made from metal such as aluminum while sandwiching therebetween an insulating layer, and the LEDs 121 are disposed on each LED substrate 120 so as to be connected to the wiring patterns 131, 132 and 133, as shown in Fig. 15.

In this case, four LEDs 121 are disposed linearly along a longitudinal direction of each LED substrate 120, and connected to one another in series by the connecting patterns 131 and 132.

The first LED 121 from the right end of each LED substrate 120 is connected to one end of the light source pattern 131. The other end of the light source pattern 131 is connected to a light-source-side terminal (positive terminal) 141 of a substrate connector 140 disposed at the right end of each LED substrate 120.

The first LED 121 from the left end of each LED substrate 120 (the fourth LED 121 from the right end) is connected to one end of the ground pattern 133. The other end of the ground pattern 133, which extends from the left end of each LED substrate 120 so as to be folded back in a rightward direction along the longitudinal direction of each LED substrate 120, is connected to a ground-side terminal (negative terminal) 142 of the substrate connector 140.

In this case, the substrate connectors 140 have a configuration of being connected to a power substrate 118 included in the liquid crystal display device 100 via cable connectors 150 and cables 161 and 162 arranged to be fitted and connected to the substrate connectors 140.

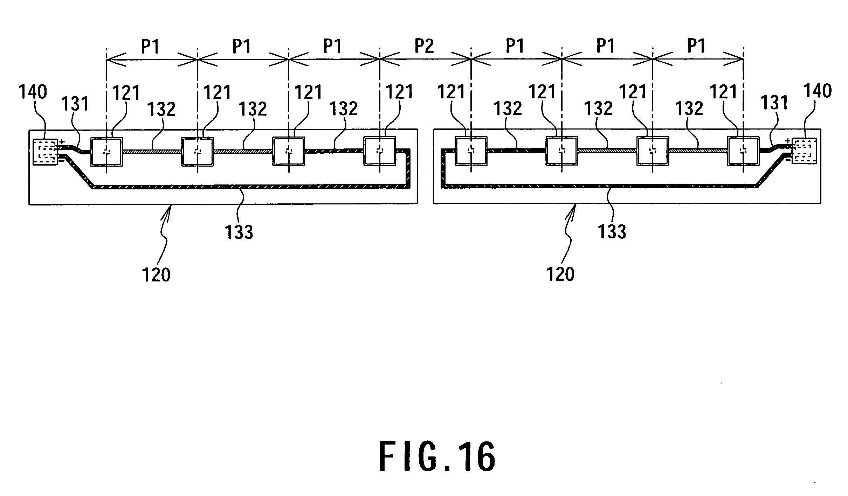

In the LED substrates 120 having the configuration described above, the substrate connectors 140 connected to the LEDs 121 are disposed at either different ones of right and left ends of the LED substrates 120. Thus, when the two LED substrates 120 are disposed laterally as shown in Fig. 16, the substrate connectors 140 of the LED substrates 120 are disposed so as not to be adjacent to each other by disposing the LED substrate 120 to the left, on which the substrate connector 140 is disposed at the left end, and disposing the LED substrate 120 to the right, on which the substrate connector 140 is disposed at the right end. This configuration allows a distance P2 between the first LED 121 from the right end of the left LED substrate 120 and the first LED 121 from the left end of the right LED substrate 120 to be equal to a distance P1 between the adjacent LEDs 121 (P2 = P1). Thus, the light from the LEDs 121 of the two LED substrates 120 can uniformly enter the light incidence surface 111a of the light guide plate 111.

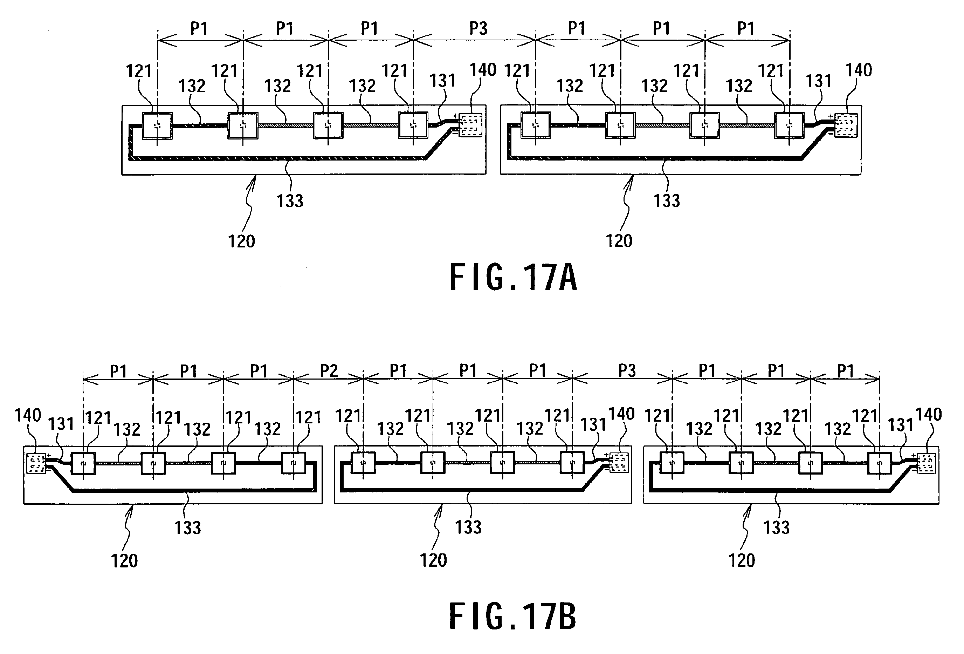

In this case, if the LED substrate 120 is disposed to the left, on which the substrate connector 140 is disposed at the right end, and the LED substrate 120 is disposed to the right, on which the substrate connector 140 is disposed at the right end as shown in Fig. 17A, a problem arises such that the cable connector 150 and the cables 161 and 162 arranged to be fitted and connected to the substrate connector 140 of the left LED substrate 120 interfere with a left end portion or the LED 121 of the right LED substrate 120.

In addition, the ends of the LED substrates 120 on the sides of the substrate connectors 140 are longer by a size of the substrate connectors 140, so that a distance P3 between the first LED 121 from the right end of the left LED substrate 120 and the first LED 121 from the left end of the right LED substrate 120 is longer than the distance P1 between the adjacent LEDs 121 (P3 > P1) as shown in Fig. 17A. Thus, the light from the LEDs 121 of the two LED substrates 120 cannot uniformly enter the light incidence surface 111a of the light guide plate 111, which causes a problem such that luminance on the light emitting surface 111b of the light guide plate 111 becomes nonuniform.

In order to prevent these problems, when the two LED substrates 120 are disposed laterally as shown in Fig. 16, the LED substrates 120 of two different kinds are prepared, on which the substrate connectors 140 are disposed at either different ones of right and left ends, and disposed so as to have the configuration that the LED substrate 120 is disposed to the left, on which the substrate connector 140 is disposed at the left end, and the LED substrate 120 is disposed to the right, on which the substrate connector 140 is disposed at the right end. A prior art literature of the present invention relates to is provided below.

### Citation List

### Patent Literature

PTL 1: JP2004-103993

### Summary of Invention

### Technical problem

However, because each of these LED substrates 120 has a configuration of including the ground pattern 133 that is adjacent to the LEDs 121, which are disposed linearly along the longitudinal direction of the LED substrate 120 and connected to one another in series, in a width direction of the LED substrate 120, and extends in the longitudinal direction of the LED substrate 120, there is a problem in downsizing the LED substrates 120 in the width direction (direction perpendicular to the longitudinal direction).

Because of this configuration, the width of the LED substrates 120 is much wider than the width of the LEDs 121 included on the LED substrates 120. Thus, the backlight chassis 114 has a configuration such that a convex portion 114c, which defines a portion of the bottom plate 114a that is protruded downward by a width for including the ground patterns 133 of the LED substrates 120, is provided, the fixing plate 115 stands on the convex portion 114c, and the LED substrates 120 are fixed to the fixing plate 115, as shown in Fig. 14. However, the convex portion 114c, which is protruded downward from the bottom plate 114a of the backlight chassis 114 , hinders achieving a thin profile of the backlight unit 104, in other words, hinders achieving a thin prof ile of the liquid crystal display device 100.

In particular, a thin profile of the liquid crystal display device 100 has been highly required recently in order to improve the design property of a liquid crystal display device such as a wall-hanging liquid crystal display device, so that the LED substrates 120 are desired to be downsized in width.

In addition, accompanied by recent increases in the size of a screen of the liquid crystal display panel 103, the backlight unit 104 increases in size, in other words, the area of the light guide plate 111 increases, so that three or more than three LED substrates 120 are sometimes desired to be disposed laterally along the light incidence surface 111a of the light guide plate 111.

However, because the LED substrates 120 of two different kinds described above have the configurations that the substrate connectors 140 connected to the LEDs 121 are disposed at either different ones of right and left ends of the LED substrates 120, the three or more than three LED substrates 120, when disposed laterally, have a problem such that the distance between the adj acent LEDs 121 of the two adjacent LED substrates 120 is not equal to the distance between the adjacent LEDs 121 of each LED substrate 120.

For example, when the three LED substrates 120 are disposed laterally as shown in Fig. 17B, the LED substrate 120 is disposed to the left, on which the substrate connector 140 is disposed at the left end, and the LED substrate 120 is disposed in the middle, on which the substrate connector 140 is disposed at the right end. Thus, distances P1 (= P2) between the LEDs 121 of the two LED substrates 120 can be made uniform. However, a distance P3 between the first LED 121 from the right end of the middle LED substrate 120, on which the substrate connector 140 is disposed at the right end, and the first LED 121 from the left end of the right LED substrate 120, on which the substrate connector 140 is disposed at the right end, is longer than the distance P1 between the adjacent LEDs 121 (P3 > P1) as shown in Fig. 17B , which causes a problem of nonuniform distances between the LEDs 121 of the two LED substrates 120.

The present invention is made in view of the problems described above, and an object of the present invention is to provide an LED substrate including a plurality of LEDs that is capable of being downsized in width, and a plurality of the LED substrates that are capable of being disposed laterally in an efficient fashion such that the distances between the adjacent LEDs are uniform, a backlight unit including the LED substrates, and a liquid crystal display device including the backlight unit.

### Solution to Problem

To achieve the objects and in accordance with the purpose of the present invention, an LED substrate of a preferred embodiment of the present invention includes a radiating plate made from metal that has a rectangular shape long-in a right/left direction, an insulating layer disposed on an upper surface of the radiating plate, a connector disposed in the middle on an upper surface of the insulating layer and including a first light-source-side terminal, a second light-source-side terminal and a ground-side terminal, a first LED group including a plurality of LEDs that are disposed to the left of the connector on the upper surface of the insulating layer linearly along a longitudinal direction of the radiating plate and connected to each another in series, a second LED group including a plurality of LEDs that are disposed to the right of the connector on the upper surface of the insulating layer linearly along the longitudinal direction of the radiating plate and connected to each other in series, a first light source pattern disposed in the middle on the upper surface of the insulating layer and connected to the first LED from the right in the first LED group, a second light source pattern disposed in the middle on the upper surface of the insulating layer and connected to the first LED from the left in the second LED group, a first ground pattern disposed at a left end on the upper surface of the insulating layer and connected to the first LED from the left in the first LED group, and a second ground pattern disposed at a right end on the upper surface of the insulating layer and connected to the first LED from the right in the second LED group, wherein the LED substrate further includes a third ground pattern disposed in the middle on the upper surface of the insulating layer, wherein the first light source pattern is connected to the first light-source-side terminal of the connector, wherein the second light source pattern is connected to the second light-source-side terminal of the connector, wherein the third light source pattern is connected to the ground-side terminal of the connector, wherein the first ground pattern is connected to the radiating plate via a first screw made from metal that is inserted in a first through-hole provided to the first ground pattern and the radiating plate, wherein the second ground pattern is connected to the radiating plate via a second screw made from metal that is inserted in a second through-hole provided to the second ground pattern and the radiating plate, and wherein the third ground pattern is connected to the radiating plate via a third screw made from metal that is inserted in a third through-hole provided to the third ground pattern and the radiating plate.

It is preferable that the metal from which the radiating plate is made defines aluminum, and the first, second and third screws define sheet-metal screws. In addition, it is preferable that conductive pastes are applied to inner surfaces of the first, second and third through-holes.

It is preferable that the LED substrate further includes a first conductive tape, one end of which is attached to the first ground pattern, and the other end is attached to the radiating plate, wherein the first ground pattern and the radiating plate are connected via the first conductive tape, a second conductive tape, one end of which is attached to the second ground pattern, and the other end is attached to the radiating plate, wherein the second ground pattern and the radiating plate are connected via the second conductive tape, and a third conductive tape, one end of which is attached to the third ground pattern, and the other end is attached to the radiating plate, wherein the third ground pattern and the radiating plate are connected via the third conductive tape.

In another aspect of the present invention, a backlight unit of a preferred embodiment of the present invention includes a light guide plate having a plate shape, an LED substrate disposed on a side surface of the light guide plate, and a chassis made from metal and arranged to house the light guide plate and the LED substrate, wherein the LED substrate includes a radiating plate made from metal that has a rectangular shape long in a right/left direction, an insulating layer disposed on an upper surface of the radiating plate, a connector disposed in the middle on an upper surface of the insulating layer and including a first light-source-side terminal, a second light-source-side terminal and a ground-side terminal, a first LED group including a plurality of LEDs that are disposed to the left of the connector on the upper surface of the insulating layer linearly along a longitudinal direction of the radiating plate and connected to each other in series, a second LED group including a plurality of LEDs that are disposed to the right of the connector on the upper surface of the insulating layer linearly along the longitudinal direction of the radiating plate and connected to each other in series, a first light source pattern disposed in the middle on the upper surface of the insulating layer and connected to the first LED from the right in the first LED group, a second light source pattern disposed in the middle on the upper surface of the insulating layer and connected to the first LED from the left in the second LED group, a first ground pattern disposed at a left end on the upper surface of the insulating layer and connected to the first LED from the left in the first LED group, and a second ground pattern disposed at a right end on the upper surface of the insulating layer and connected to the first LED from the right in the second LED group, wherein the LED substrate further includes a third ground pattern disposed in the middle on the upper surface of the insulating layer, wherein the first light source pattern is connected to the first light-source-side terminal of the connector, wherein the second light source pattern is connected to the second light-source-side terminal of the connector, wherein the third light source pattern is connected to the ground-side terminal of the connector, wherein the first ground pattern is connected to the radiating plate via a first screw made from metal that is inserted in a first through-hole provided to the first ground pattern and the radiating plate, wherein the second ground pattern is connected to the radiating plate via a second screw made from metal that is inserted in a second through-hole provided to the second ground pattern and the radiating plate, and wherein the third ground pattern is connected to the radiating plate via a third screw made from metal that is inserted in a third through-hole provided to the third ground pattern and the radiating plate.

It is preferable that the metal from which the radiating plate is made defines aluminum, and the first, second and third screws define sheet-metal screws. In addition, it is preferable that conductive pastes are applied to inner surfaces of the first, second and third through-holes.

It is preferable' that the backlight unit further includes a first conductive tape, one end of which is attached to the first ground pattern, and the other end is attached to the radiating plate, wherein the first ground pattern and the radiating plate are connected via the first conductive tape, a second conductive tape, one end of which is attached to the second ground pattern, and the other end is attached to the radiating plate, wherein the second ground pattern and the radiating plate are connected via the second conductive tape, and a third conductive tape, one end of which is attached to the third ground pattern, and the other end is attached to the radiating plate, wherein the third ground pattern and the radiating plate are connected via the third conductive tape.

It is preferable that the backlight unit further includes a fixing plate made from metal that is disposed to stand on the chassis, wherein the LED substrate is fixed to the fixing plate by the first, second and third screws, and wherein the radiating plate is electrically connected to the chassis via the fixing plate.

It is preferable that the backlight unit further includes a thermal conductive sheet disposed between the fixing plate and the radiating plate of the LED substrate. It is also preferable that the thermal conductive sheet possesses electrical conductivity.

Yet, in another aspect of the present invention, a liquid crystal display device of a preferred embodiment of the present invention includes a liquid crystal display panel, and the backlight unit of the above-described embodiment of the present invention that is disposed behind the liquid crystal display panel. Advantageous Effects of Invention

In the LED substrate, the backlight unit and the liquid crystal display device having the configurations described above, the radiating plate, which is made from metal and disposed under the LEDs that are connected in series while sandwiching therebetween the insulating layer, is used as a ground wire for the LEDs. Thus, it is unnecessary to provide a ground pattern shown in Fig. 15 and explained above in the description of Background Art, which is adjacent to the LEDs, which are disposed linearly along the longitudinal direction of the LED substrate and connected to one another in series, in the width direction of the LED substrate, and extends linearly along the longitudinal direction of the LED substrate.

Thus, downsizing (decreasing) in width of the LED substrate by a width that is required in order to include the ground pattern disposed linearly along the longitudinal direction of the LED substrate can be achieved, whereby a thin profile of the backlight unit, inotherwords, athinprofileof the liquid crystal display device can be achieved, which improves the design property of the liquid crystal display device.

In addition, the LED substrate of the present invention has the configuration that the connector arranged to supply power to the LEDs is disposed in the middle of the LED substrate, which is different from the configuration of the LED substrate 120 explained above in the description of Background Art that the substrate connector 140 is disposed at either one of right and left ends of the LED substrate 120. Thus, the right and left ends of the LED substrate of the present invention can have the same shape.

Thus, the distances between the LEDs of the plurality of LED substrates can be made uniform even when the plurality of LED substrates are disposed laterally, which prevents the problem that the distance P3 between the LEDs 121 of the two adjacent LED substrates 120 is longer than the distance P1 between the LEDs 121 of each LED substrate 120, which is shown in Figs. 17A and 17B and explained above in the description of Background Art.

In addition, because the right and left ends of the LED substrate of the present invention have the same shape owing to the configuration that the connector is disposed in the middle of the LED substrate, the LED substrates of one kind having an above-described configuration can suffice when two, three or more than three LED substrates are disposed laterally. Thus, it is unnecessary to prepare LED substrates of two different kinds on which substrate connectors are disposed at either different ones of right and left ends of the LED substrates, which are conventionally used, whereby the number of components can be reduced to save a cost.

### Brief Description of Drawings

Fig. 1 is an exploded perspective view showing a schematic configuration of a liquid crystal display device of a preferred embodiment of the present invention.
Fig. 2 is an enlarged cross-sectional view showing a relevant portion of the liquid crystal display device shown in Fig. 1 after being assembled.
Fig. 3 is an external perspective view showing a schematic configuration of an LED substrate of a preferred embodiment of the present invention.
Fig. 4 is a front plan view showing the LED substrate shown in Fig. 3.
Fig. 5A is a vertical cross-sectional view showing the LED substrate shown in Fig. 3, and Fig. 5B is a longitudinal cross-sectional view showing a substrate connector of the LED substrate shown in Fig. 5A on the side of a ground-side terminal.
Fig. 6A is a cross-sectional view showing the LED substrate shown in Fig. 5A, where sheet-metal screws are inserted in the LED substrate, and Fig. 6B is a cross-sectional view showing the LED substrate shown in Fig. 5B, where a sheet-metal screw is inserted in the LED substrate.
Fig. 7 is an external perspective view showing the LED substrate and a fixing plate to which the LED substrate is to be fixed.
Figs. 8A is a vertical cross-sectional view showing the LED substrate and the fixing plate shown in Fig. 7, and Fig. 8B is a longitudinal cross-sectional view showing the substrate connector of the LED substrate shown in Fig. 8A on the side of the ground-side terminal.
Fig. 9 is a plan view showing three LED substrates that are laterally disposed.
Fig. 10A is a vertical cross-sectional view showing the LED substrate of a first modified embodiment, and Fig. 10B is a longitudinal cross-sectional view showing the substrate connector of the LED substrate shown in Fig. 10A on the side of the ground-side terminal.
Fig. 11A is a vertical cross-sectional view showing the LED substrate of a second modif ied embodiment, and Fig. 11B is a longitudinal cross-sectional view showing the substrate connector of the LED substrate shown in Fig. 11A on the side of the ground-side terminal.
Fig. 12 is a plan view showing the LED substrate of a third modified embodiment.
Fig. 13 is an exploded perspective view showing a schematic configuration of a conventional liquid crystal display device.
Fig. 14 is an enlarged cross-sectional view showing a relevant portion of the liquid crystal display device shown in Fig. 13 after being assembled.
Fig. 15 is a front plan view showing a conventional LED substrate.
Fig. 16 is a plan view showing two conventional LED substrates that are laterally disposed.
Fig. 17A is a plan view showing two conventional LED substrates that are laterally disposed, and Fig. 17B is a plan view showing three conventional LED substrates that are laterally disposed

### Description of Embodiments

A detailed description of an LED substrate, a backlight unit, and a liquid crystal display device of preferred embodiments of the present invention will now be provided with reference to the accompanying drawings.

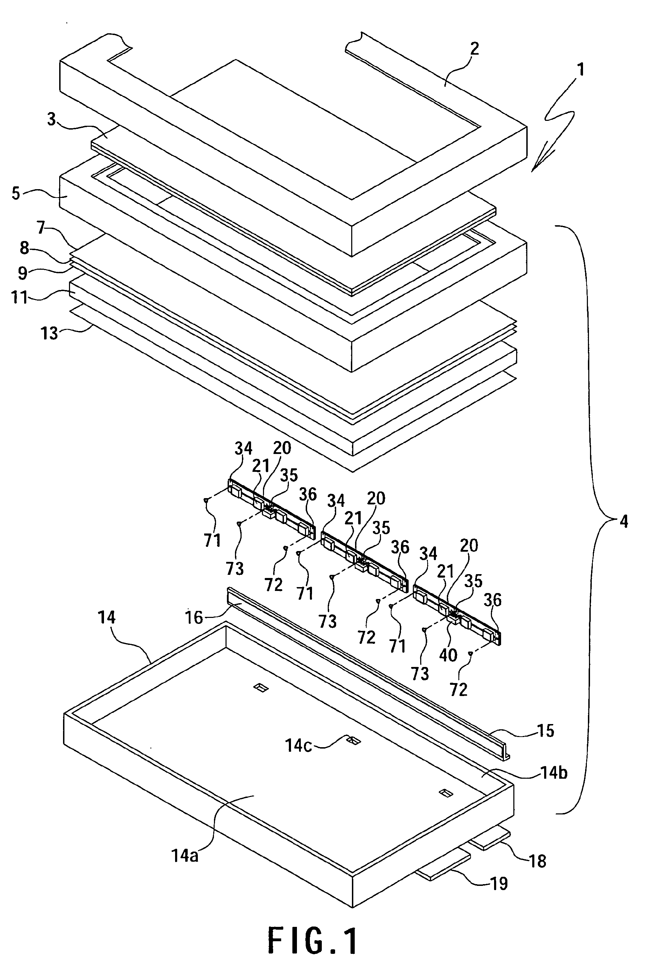

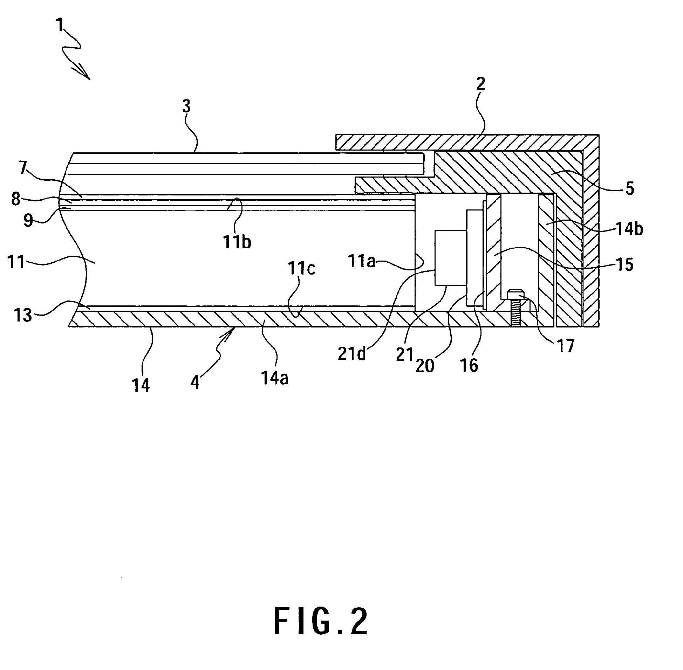

Fig. 1 is an exploded perspective view showing a schematic configuration of a liquid crystal display device 1 of a preferred embodiment of the present invention. Fig. 2 is an enlarged cross-sectional view showing a relevant portion of the liquid crystal display device 1. The liquid crystal display device 1 includes a bezel 2, a liquid crystal display panel 3 and a backlight unit 4 as shown in Figs. 1 and 2.

The bezel 2 has a square frame shape with an opening so as to cover edge portions of the liquid crystal display panel 3, and is arranged to, together with a backlight chassis 14 to be described later, ensure strength of the entire liquid crystal display device 1. The liquid crystal display panel 3 includes two glasses that are bonded together, and liquid crystals are filled in a space between the glasses. The liquid crystal display panel 3 is capable of displaying an image on its front surface.

The backlight unit 4 defines a so-called side (edge) illuminating device. The backlight unit 4 includes a frame 5, optical sheets 7 to 9, a light guide plate 11, a reflection sheet 13, the backlight chassis 14, a fixing plate 15, and three LED substrates 20 as shown in Fig. 1. The frame 5 has a square frame shape with an opening, and is arranged to fix the optical sheets 7 to 9, the light guide plate 11 and the reflection sheet 13, which are stacked in this order from the top, to the backlight chassis 14. The optical sheets 7 to 9, the light guide plate 11 and the reflection sheet 13 define optical members arranged to adjust the properties (e.g., refraction, diffraction, reflection) of light that enters the liquid crystal display panel 3 from LEDs 21 included on the LED substrates 20.

The backlight chassis 14 is made of a metal plate such as aluminum that possesses electrical conductivity. The backlight chassis 14 has the shape of a box of low height that is formed through bending processing of the metal plate. The backlight chassis 14 houses the optical sheets 7 to 9, the light guide plate 11, the reflection sheet 13, the fixing plate 15, and the LED substrates 20.

The light guide plate 11 has a rectangular shape when seen in a plan view, and is preferably made of a transparent plate having a thickness of about 3 to 4 mm. The light guide plate 11 includes a light incidence surface 11a arrange to obtain light from the LEDs 21, and a light emitting surface 11b arrange to emit the light upward (in a direction to project the light) obtained from the light incidence surface 11a. The light incidence surface 11a is defined by a given side surface of the light guide plate 11, and the light emitting surface 11b is defined by a front surface of the light guide plate 11.

The light guide plate 11 is arranged to repeatedly reflect the light, which enters from the light incidence surface 11a, between the light emitting face (front face) 11b and a back surface 11c, which is the opposite surface to the light emitting surface 11b, to planarly diffuse the light inside the light guide plate 11. The light guide plate 11 includes a plurality of scattering members (not shown) on the back surface 11c, which are arranged to scatter the light, which enters from the light incidence surface (side surface) 11a, and emit the light from the light emitting surface (front surface) 11b. The scattering members are preferably provided thereon by dotting paint containing a white pigment in a printing method on the back surface 11c of the light guide plate 11, or are preferably provided thereon by forming a plurality of concave portions on the back surface 11c of the light guide plate 11.

In addition, the LEDs 21 provided to the LED substrates 20 are disposed close to the light incidence surface 11a of the light guide plate 11. Further, light emitting surfaces 21d of the LEDs 21 are disposed along the light incidence surface 11a of the light guide plate 11, having a given space therebetween so as to be opposed to the light incidence surface 11a. In the present embodiment, the three LED substrates 20 are fixed so as to be disposed laterally while standing (erecting) on the fixing plate 15 having the shape of the letter "L" that is provided so as to stand on a bottom plate 14a in the vicinity of a side wall 14b of the backlight chassis 14.

The reflection sheet 13 is disposed so as to cover the back surface 11c, which is the opposite surface to the light emitting surface 11b. In the present embodiment, the reflection sheet 13 is disposed on the bottom plate 14a of the backlight chassis 14. The reflection sheet 13 is arranged to reflect the light, which is emitted from the back surface 11c of the light guide plate 11, toward the light guide plate 11. The reflection sheet 13 preferably defines a resin sheet having a thickness of about 0.1 to 2 mm. The reflection sheet 13 is preferably painted white to increase use efficiency of the light and to enhance brightness of the light on the light emitting surface 11b of the light guide plate 11 by efficiently reflecting the light, which is emitted from the back surface 11c of the light guide plate 11, toward the light guide plate 11.

The three optical sheets 7 to 9 define resin sheets, which have a thin rectangular shape when seen in a plan view. The three optical sheets 7 to 9 are defined by a stack of the polarization selective reflection sheet 7, the lens sheet 8, and the diffusion sheet 9, which have a thickness of about 0.1 to 0.5 mm, and are stacked in this order from the top and disposed on the light guide plate 11.

In the present embodiment, the diffusion sheet 9 is used to diffuse the light emitted from the light guide plate 11, allowing uniformalization of brightness distribution of the light. The lens sheet 8 is used to gather the light emitted from the diffusion sheet 9, allowing enhancement of front brightness of the light. The polarization selective reflection sheet 7 is used to selectively reflect the light emitted from the lens sheet 8 so that the light is not absorbed by a polarizing plate (not shown) that is attached on the underside of the liquid crystal display panel 3.

The backlight unit 4 is capable of converting the light from the LEDs 21 into planate light with the use of the optical sheets 7 to 9, the light guide plate 11 and the reflection sheet 13, and projecting the light onto a back surface of the liquid crystal display panel 3. A power board 18 arranged to supply power to the LED substrates 20, and a control board 19 arranged to drive the liquid crystal display panel 3 are provided behind the backlight chassis 4.

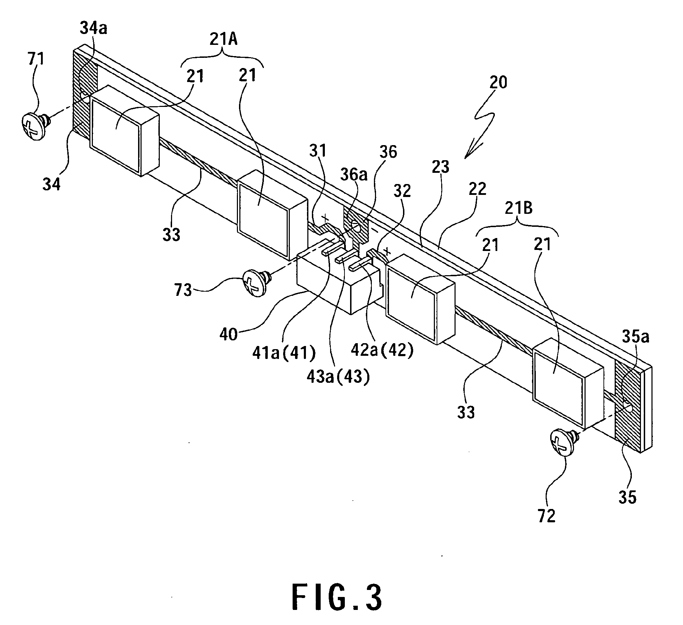

Next, a description of the LED substrates 20 of the present embodiment of the present invention will be provided with reference to Figs. 3 to 7. Each of the LED substrates 20 includes a radiating plate 22 made from metal such as aluminum that possesses electrical conductivity as shown in Figs. 3 to 7. The radiating plates 22 have a long rectangular shape. Insulating layers 23 are disposed on upper surfaces of the radiating plates 22. The plurality of LEDs 21 (four LEDs 21 per LED substrate 20 in the present embodiment) disposed linearly along a longitudinal direction of the LED substrates 20 (the radiating plates 22) are disposed on the insulating layers 23.

In the present embodiment, the radiating plates 22 function as base members of the LED substrates 20, and function to curb an increase in temperature caused by heat generation of the LEDs 21. The radiating plates 22 are attached and fixed to the fixing plate 15 while sandwiching therebetween a thermal conductive sheet 16 that has adhesive faces on both sides. The fixing plate 15 has the shape of the letter "L", is made from metal such as aluminum that possesses electrical conductivity, and is disposed so as to stand on the bottom plate 14a of the backlight chassis 14 (see Fig. 2).

Thus, the heat generated by the LEDs 21 is conveyed to the bottom plate 14a of the backlight chassis 14 via the radiating plates 22 of the LED substrates 20, the thermal conductive sheet 16 and the fixing plate 15, so that the temperature of the LEDs 21 is curbed not to increase excessively. The fixing plate 15 is attached to the bottom plate 14a of the backlight chassis 14 by a fixation screw 17.

Each of the LEDs 21 has a package structure such that an LED chip 21a that emits blue light is encapsulated in a transparent resin into which a yellow fluorescent material is mixed, for example, and is capable of emitting white light from its top surface, i.e. , the light emitting surface 21d. In the present embodiment, the light emitting surfaces 21d are disposed parallel to plate faces (surfaces) of the LED substrates 20.

A first ground pattern 34, a connecting pattern 33, a first light source pattern 31, a third ground pattern 36, a second light source pattern 32, a connecting pattern 33, and a second ground pattern 35 that define wiring patterns are provided in this order from the left on each insulating layer 23 as shown in Figs. 3, 4 and 5A. The two LEDs 21 that are disposed in an area of a left half from the middle of the LED substrate 20 (a first LED group 21A) are connected to each other in series by the connecting pattern 33, and the two LEDs 21 that are disposed in an area of a right half from the middle of the LED substrate 20 (a second LED group 21B) are connected to each other in series by the connecting pattern 33.

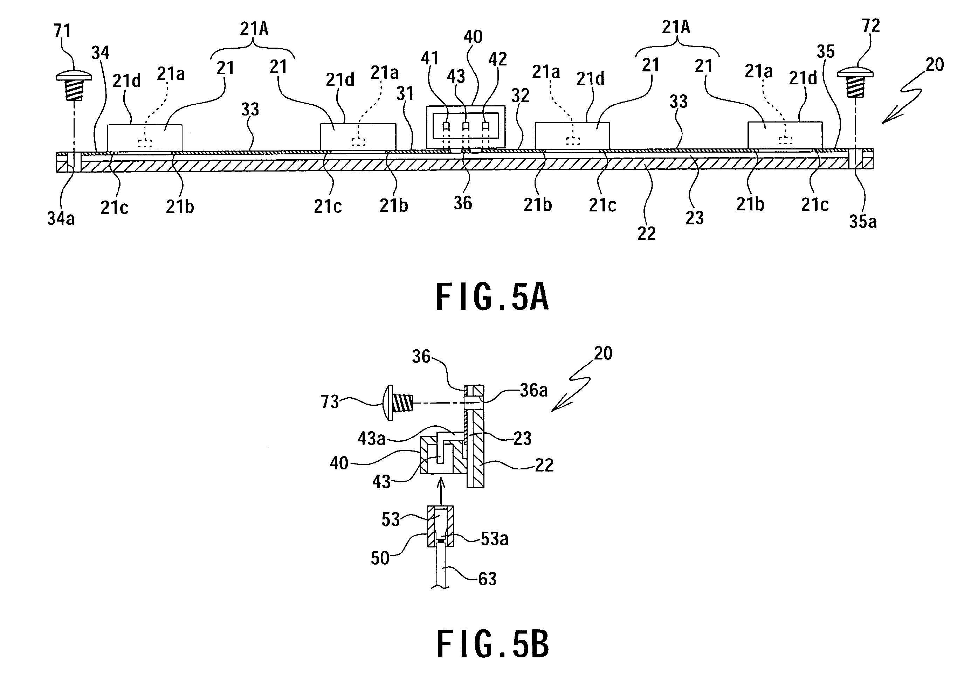

To be specific, a positive electrode (anode electrode) 21b of the first LED 21 from the left in the first LED group 21A and a negative electrode (cathode electrode) 21c of the second LED 21 from the left in the first LED group 21A are connected by the connecting pattern 33, and a positive electrode (anode electrode) 21b of the first LED 21 from the right in the second LED group 21B and a negative electrode (cathode electrode) 21c of the second LED 21 from the right in the second LED group 21B are connected by the connecting pattern 33, as shown in Fig. 5A.

A white coating such as a white solder resist is printed on the surfaces of the LED substrates 20 in a silk printing method so that the surfaces are coated with the coating (not shown). The silk printing method is defined by a method of covering a subject to be printed with a silk that functions as a screen, in which an opening with a given pattern is formed, and then printing ink in the subject through the opening, which is also called as a silk screening method.

In the present embodiment, the white coating is printed on the surface of each LED substrate 20 except the areas where the LEDs 21 and the first, second and third ground patterns 34, 35 and 36 are disposed. Thus, the white coating reflects the light that comes back to the LED substrates 20 from the light incidence surface 11a of the light guide plate 11, which increases use efficiency of the light.

In addition, a substrate connector 40 is provided to each LED substrate 20. The substrate connectors 40 are disposed in the almost middles of the LED substrates 20 between the first LED groups 21A and the seconds LED group 21B. The substrate connectors 40 are used to supply electric source (power) to the LEDs 21, and each substrate connector 40 includes a first male light-source-side terminal (positive terminal) 41, a second male light-source-side terminal (positive terminal) 42 and a male ground-side terminal (negative terminal) 43.

In the present embodiment, the substrate connectors 40 have a configuration of being connected to the power board 18 of the liquid crystal display device 1 via cable connectors 50 and cables 61, 62 arranged to be fitted and connected from below to the substrate connectors 40.

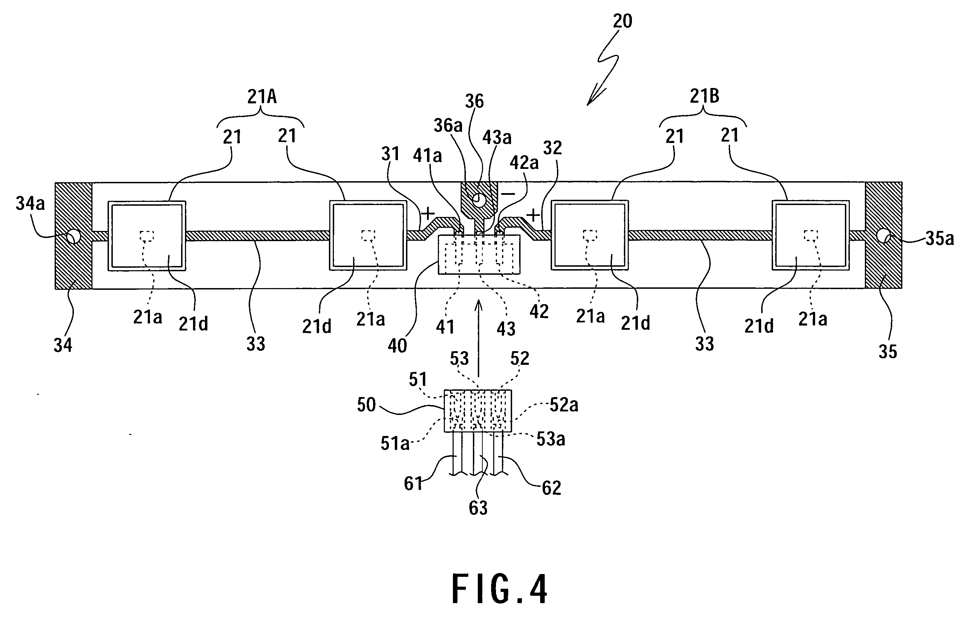

In the present embodiment, each substrate connector 40 is disposed such that its fitting surface faces downward in a direction parallel to a width direction of each LED substrate 20 (in a lateral direction) so that each connector 50 is fitted and connected thereto from below as shown in Fig. 4. The first light-source-side terminal 41, the ground-side terminal 43 and the second light-source-side terminal 42 are disposed in this order from the left to the right in a connector housing of each substrate connector 40.

Each cable connector 50 includes a first female light-source-side terminal (positive terminal) 51, a second female light-source-side terminal (positive terminal) 52, and a female ground-side terminal (negative terminal) 53, which are arranged to be fitted and electrically connected to the first light-source-side terminal 41, the second light-source-side terminal 42 and the ground-side terminal 43 of each substrate connector 40, respectively, as shown in Fig. 4. In the present embodiment, each cable connector 50 has a configuration such that the first light-source-side terminal 51, the ground-side terminal 53 and the second light-source-side terminal 52 are disposed in this order from the left to the right in a connector housing of each cable connector 50 so as to correspond to each substrate connector 40 to which each cable connector 50 is to be connected.

A crimping portion 51a of the first light-source-side terminal 51 of each cable connector 50 is connected to an end portion of the first light-source-side cable 61, a crimping portion 52a of the second light-source-side terminal 52 of each cable connector 50 is connected to an end portion of the second light-source-side cable 62, and a crimping portion 53a of the ground-side terminal 53 of each cable connector 50 is connected to an end portion of the ground-side cable 63.

The first light source pattern 31 is connected to the positive electrode (anode electrode) 21b of the first LED 21 from the right in the first LED group 21A, and is also connected to a tip 41a of the first light-source-side terminal (positive terminal) 41 of the substrate connector 40 as shown in Figs. 3, 4 and 5A. The second light source pattern 32 is connected to the positive electrode (anode electrode) 21b of the first LED 21 from the left in the second LED group 21B, and is also connected to a tip 42a of the second light-source-side terminal (positive terminal) 42 of the substrate connector 40. The third ground pattern 36 having a square shape (a substantially rectangular shape) that is disposed above the substrate connector 40 is connected to a tip 43a of the ground-side terminal (negative terminal) 43 of the substrate connector 40.

In addition, the first ground pattern 34 having a square shape (a substantially rectangular shape) that is disposed at the left end of each LED substrate 20 is connected to the negative electrode (cathode electrode) 21c of the first LED 21 from the left in the first LED group 21A. Further, the second ground pattern 35 having a square shape (a substantially rectangular shape) that is disposed at the right end of each LED substrate 20 is connected to the negative electrode (cathode electrode) 21c of the first LED 21 from the right in the second LED group 21B.

A first through-hole 34a that goes through the first ground pattern 34, the insulating layer 23 and the radiating plate 22 is formed in the middle of the first ground pattern 34 as shown in Figs. 3, 4 and 5A. A second through-hole 35a that goes through the second ground pattern 35, the insulating layer 23 and the radiating plate 22 is formed in the middle of the second ground pattern 35. A third through-hole 36a that goes through the third ground pattern 36, the insulating layer 23 and the radiating plate 22 is formed in the middle of the third ground pattern 36.

In each LED substrate 20 having the configuration described above, the light-source-side terminal 41 of the substrate connector 40 is electrically connected to the LEDs 21 in the first LED group 21A by the first light source pattern 31 and the connecting patterns 33, while the first ground pattern 34 is not connected to the third ground pattern 36. Thus, the negative electrode (cathode electrode) 21c of the first LED 21 from the left in the first LED group 21A is yet to be connected to the ground-side terminal 43 of the substrate connector 40.

In a similar manner, the light-source-side terminal 42 of the substrate connector 40 is electrically connected to the LEDs 21 in the second LED group 21B by the second light source pattern 32 and the connecting patterns 33, while the second ground pattern 35 is not connected to the third ground pattern 36. Thus, the negative electrode (cathode electrode) 21c of the first LED 21 from the right in the second LED group 21B is yet to be connected to the ground-side terminal 43 of the substrate connector 40.

Thus, a first sheet-metal screw 71 and a third sheet-metal screw 73 that are made from metal that possesses electrical conductivity are inserted into the first through-hole 34a of the first ground pattern 34 and the third through-hole 36a of the third ground pattern 36, respectively, so that the first ground pattern 34 is electrically connected to the radiating plate 22 disposed thereunder via the first sheet-metal screw 71, and the third ground pattern 36 is electrically connected to the radiating plate 22 disposed thereunder via the third sheet-metal screw 73, which allows the first ground pattern 34 and the third ground pattern 36 to be electrically connected to each other via the first sheet-metal screw 71, the radiating plate 22 and the third sheet-metal screw 73, as shown in shown in Figs. 3, 5A and 5B.

In a similar manner, a second sheet-metal screw 72 and the third sheet-metal screw 73 that are made from metal that possesses electrical conductivity are inserted into the second through-hole 35a of the second ground pattern 35 and the third through-hole 36a of the third ground pattern 36, respectively, so that the second ground pattern 35 is electrically connected to the radiating plate 22 disposed thereunder via the second sheet-metal screw 72, and the third ground pattern 36 is electrically connected to the radiating plate 22 disposed thereunder via the third sheet-metal screw 73, which allows the second ground pattern 35 and the third ground pattern 36 to be electrically connected to each other via the second sheet-metal screw 72, the radiating plate 22 and the third sheet-metal screw 73, as shown in shown in Figs. 3, 5A and 5B.

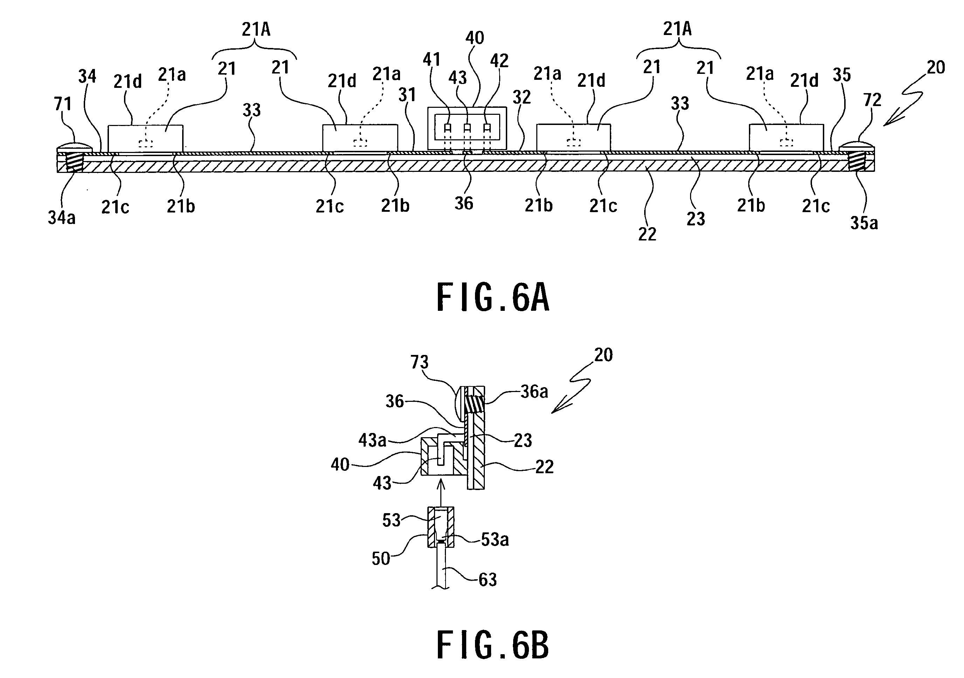

Thus, the two LEDs 21 that are connected in series in the first LED group 21A are made connected in series between the first light-source-side terminal 41 and the ground-side terminal 43 of the substrate connector 40, and the two LEDs 21 that are connected in series in the second LED group 21B are made connected in series between the second light-source-side terminal 42 and the ground-side terminal 43 of the substrate connector 40 as shown in Figs. 6A and 6B.

In other words, because each LED substrate 20 has the configuration that the first ground pattern 34 disposed at the left end of the LED substrate 20 and the second ground pattern 35 disposed at the right end of the LED substrate 20 are electrically connected to the third ground pattern 36 that is connected to the ground-side terminal 43 of the substrate connector 40 via the first sheet-metal screw 71, the second sheet-metal screw 72, the radiating plate 22 and the third sheet-metal screw 73, it is unnecessary to provide the ground pattern 133 shown in Fig. 15 and explained above in the description of Background Art, which is adjacent to the LEDs 121, which are connected to one another in series in the longitudinal direction of the LED substrate 120, in the width direction of the LED substrate 120, and extends along the longitudinal direction of the LED substrate 120.

Thus, downsizing (decreasing) in width of each LED substrate 20 by a width that is required in order to include the conventional ground pattern 133 disposed linearly along the longitudinal direction of the LED substrate 120 can be achieved by using the radiating plate 22 made from metal as a ground wire for the LEDs 21, the radiating plate 22 being disposed under the LEDs 21 connected in series while sandwiching therebetween the insulating layer 23.

That is, downsized in their width direction (direction perpendicular to the longitudinal direction) , the LED substrates 20 can be housed in the backlight chassis 14 as shown in Fig. 2 without providing the convex portion 114c shown in Fig. 14 and explained above in the description of Background Art, which defines the portion protruded downward from the bottom plate 114a of the backlight chassis 114.

Thus, the height of the backlight chassis 14 (the height from the bottom plate 14a) can be reduced compared with a conventional backlight chassis as shown in Fig. 2, which can achieve a thin profile of the backlight unit 4, and a thin profile of the liquid crystal display device 1.

It is also preferable to have a configuration such that normally-used screw holes are provided instead of the first through-hole 34a of the first ground pattern 34, the second through-hole 35a of the second ground pattern 35, and the third through-hole 36a of the third ground pattern 36, and normally-used screws are provided instead of the first sheet-metal screw 71, the second sheet-metal screw 72, and the third sheet-metal screw 73.

In the present embodiment, by inserting the first sheet-metal screw 71 into the first through-hole 34a of the first ground pattern 34 to electrically connect the first ground pat tern 34 and the radiating plate 22 disposed under the first ground pattern 34, a thread of the first sheet-metal screw 71 is engaged in the inner surface of the first through-hole 34a to be transformed to a female screw. Thus, it is unnecessary to form the first through-hole 34a as a screw hole. In addition, the first sheet-metal screw 71 can be electrically connected to the radiating plate 22 in a convincing way.

In addition, in a similar manner, by inserting the second sheet-metal screw 72 into the second through-hole 35a of the second ground pattern 35 to electrically connect the second ground pattern 35 and the radiating plate 22 disposed under the second ground pattern 35, a thread of the second sheet-metal screw 72 is engaged in the inner surface of the second through-hole 35a to be transformed to a female screw. Thus, it is unnecessary to form the second through-hole 35a as a screw hole. In addition, the second sheet-metal screw 72 can be electrically connected to the radiating plate 22 in a convincing way.

In addition, in a similar manner, by inserting the third sheet-metal screw 73 into the third through-hole 36a of the third ground pattern 36 to electrically connect the third ground pattern 36 and the radiating plate 22 disposed under the third ground pattern 36, a thread of the third sheet-metal screw 73 is engaged in the inner surface of the third through-hole 36a to be transformed to a female screw. Thus, it is unnecessary to form the third through-hole 36a as a screw hole. In addition, the third sheet-metal screw 73 can be electrically connected to the radiating plate 22 in a convincing way.

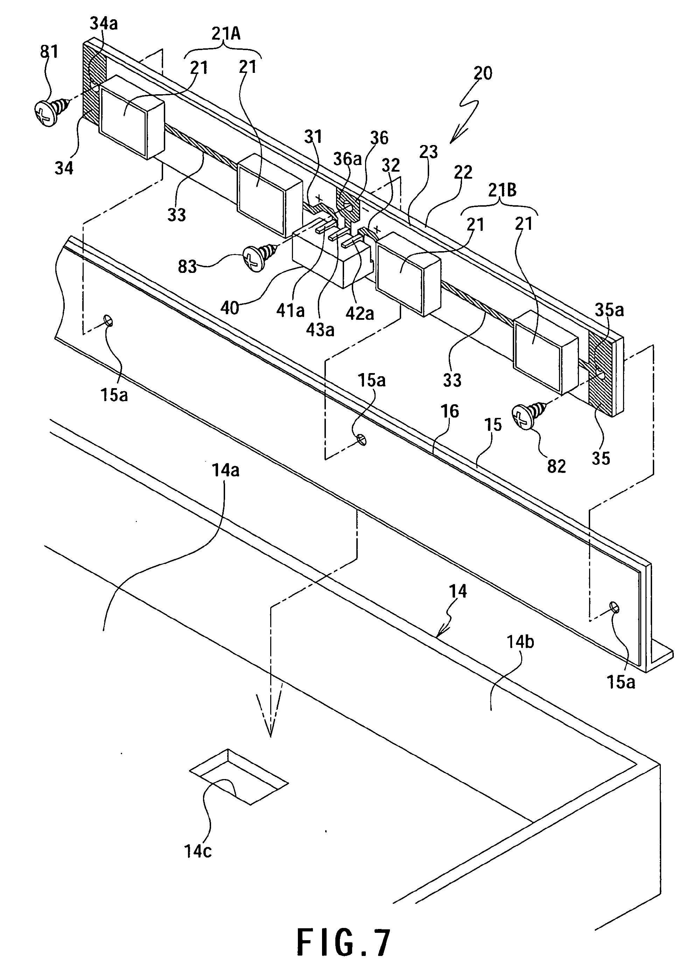

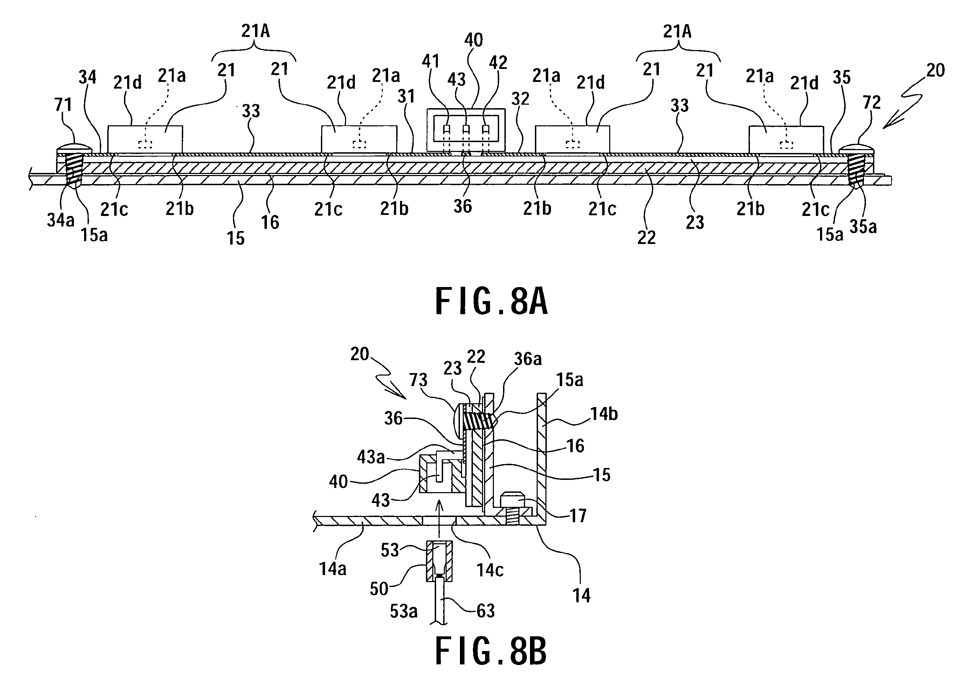

It is also preferable that first, second and third sheet-metal screws 81, 82 and 83 are used instead of the first, second and third sheet-metal screws 71, 72 and 73, the first, second and third sheet-metal screws 81, 82 and 83 being longer than the first, second and third sheet-metal screws 71, 72 and 73, and front ends of the first, second and third sheet-metal screws 81, 82 and 83 are inserted into through-holes 15a provided to the fixing plate 15 and the thermal conductive sheet 16 as shown in Figs. 7, 8A and 8B . This configuration allows not only electrical connection between the first ground pattern 34 and the radiating plate 22, electrical connection between the second ground pattern 35 and the radiating plate 22, and electrical connection between the third ground pattern 36 and the radiating plate 22, but also attachment of the LED substrates 20 to the fixing plate 15.

The backlight chassis 14 usually functions as a grounding member arranged to electrically ground the power board 18 arranged to supply power to the LED substrates 20 and the control board 19 arranged to drive the liquid crystal display panel 3. Thus, in the configuration shown in Figs. 7, 8A and 8B, the first ground pattern 34, the second ground pattern 35 and the third ground pattern 36 of each LED substrate 20 are electrically connected to the backlight chassis 14 that functions as the grounding member via the sheet-metal screws 81, 82 and 83, the radiating plate 22 and the fixing plate 15. Thus, electrical grounding properties of the first ground pattern 34, the second ground pattern 35 and the third ground pattern 36 of each LED substrate 20 are improved, which allows stable power supply to the LEDs 21.

If a thermal conductive sheet that possesses electrical conductivity is used as the thermal conductive sheet 16 that is sandwiched between the radiating plate 22 of the LED substrate 20 and the fixing plate 15, electrical grounding properties of the first ground pattern 34, the second ground pattern 35 and the third ground pattern 36 of each LED substrate 20 are further improved.

Openings 14c for connector insertion are provided to the bottom plate 14a of the backlight chassis 14, the openings 14 being larger than the outer diameters of the cable connectors 50 such that the cable connectors 50 are insertable in and removable from the substrate connectors 40 of the LED substrates 20 that are fixed to the bottom plate 14a of the backlight chassis 14 as shown in Figs. 1, 7 and 8B. This configuration allows easy handleability of the cable connectors 50, and easy wiring of the cables 61, 62 and 63 to the power board 18 disposed behind the bottom plate 14a.

As described above, the LED substrates 20 have the configuration that the substrate connectors 40 arranged to supply power to the LEDs 21 included on the LED substrates 20 are disposed in the middles of the LED substrates 20, so that the right and left ends of the LED substrates 20 can have the same shape, especially in this case, the symmetrically same shape as shown in Fig. 4. Thus, distances between the LEDs 21 of the plurality of LED substrates 20 can be made uniform even when the plurality of LED substrates are disposed laterally.

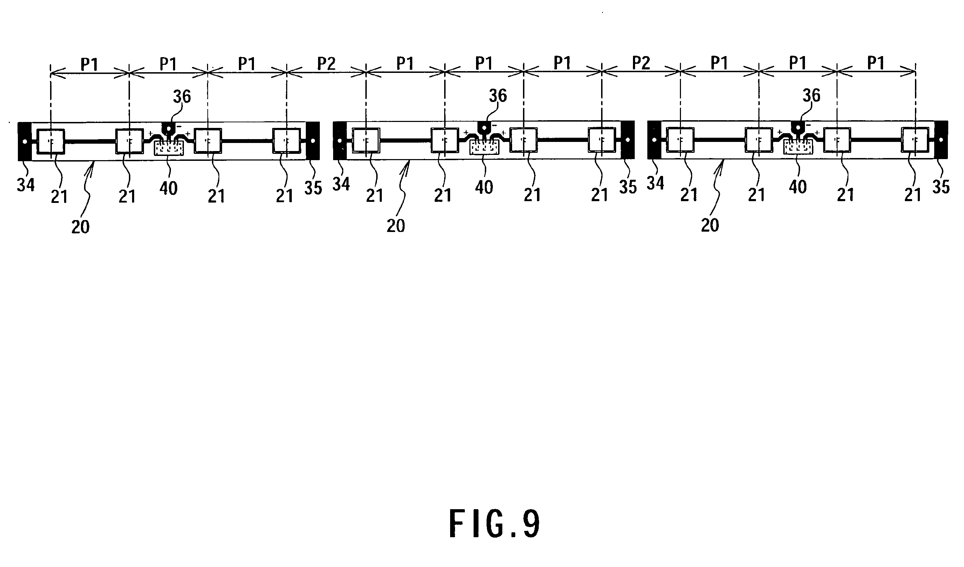

When three LED substrates 20 are disposed laterally in the longitudinal direction thereof, distances P2 between the adjacent LEDs 21 of the adjacent LED substrates 20 can be made equal to distances P1 between the adjacent LEDs 21 of each LED substrate 20 as shown in Fig. 9. Thus, the three LED substrates 20 can be disposed such that the distances between the LEDs 21 are all uniform.

That is, the LED substrates 20 of the present invention do not have the configuration that the substrate connectors 140 are disposed at either different ones of right and left ends of the LED substrates 120, which is shown in Fig. 15 and explained above in the description of Background Art. Thus, the problem that a distance between the LEDs 121 of the two adjacent LED substrates 120 is longer, which is indicated as P3 in Figs. 17A and 17B, can be prevented. Thus, the plurality of LED substrates can be disposed laterally in an efficient fashion such that the distances between the adjacent LEDs are all uniform.

In addition, owing to the configuration of the LED substrates 20 that the substrate connectors 40 are disposed in the middles of the LED substrates 20, the LED substrates of one kind having this configuration can suffice when two, three or more than three LED substrates are disposed laterally. Thus, it is unnecessary to prepare the LED substrates 120 of two different kinds on which the substrate connectors 140 are disposed at different one ends of the right and left ends of the LED substrates 120 as shown in Fig. 16, which can reduce the number of components and save a cost.

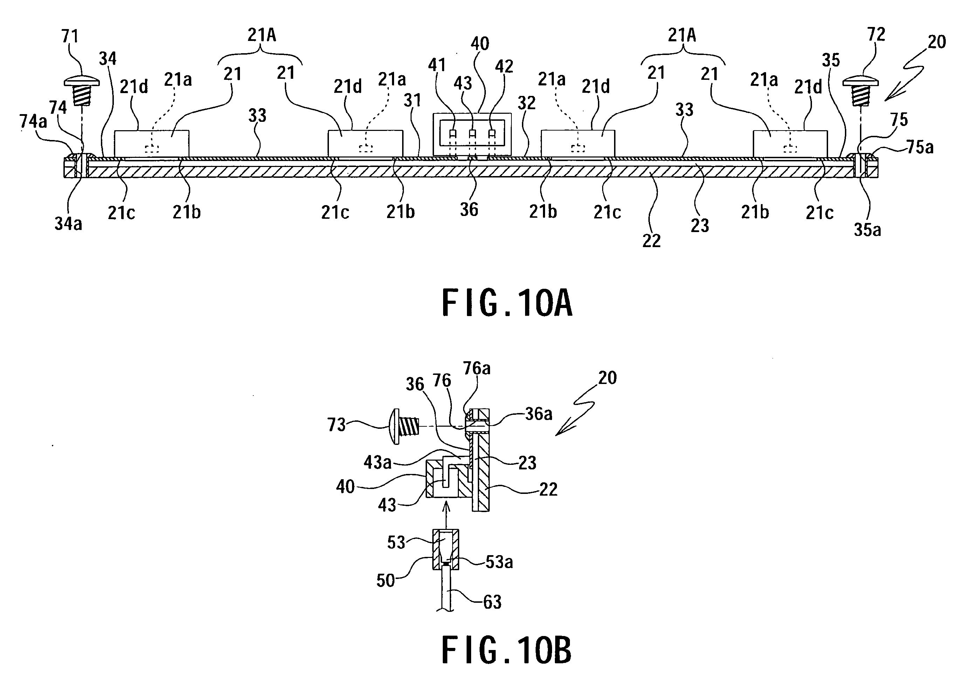

Next, descriptions of first to third modified embodiments of the above-described embodiment will be provided with reference to Figs. 10A to 12. Explanations of the same components as those in the above-described embodiment are omitted, and different respects are explained mainly, providing the same reference numerals as those in the above-described embodiment to the same components.

Figs. 10A and 10B are a view showing the LED substrate 20 of the first modified embodiment, where conductive pastes 74, 75 and 76 preferablymade from solder are applied to inner surfaces of the first through-hole 34a of the first ground pattern 34, the second through-hole 35a of the second ground pattern 35, and the third through-hole 36a of the third ground pattern 36. Inserting the sheet-metal screws 71, 72 and 73 into the through-holes 34a, 35a and 36a, to the inner surfaces of which the conductive pastes 74, 75 and 76 are applied, can further improve electrical connection between the first ground pattern 34 and the radiating plate 22, electrical connection between the second ground pattern 35 and the radiating plate 22, and electrical connection between the third ground pattern 36 and the radiating plate 22.

It is preferable to provide raised portions 74a, 75a and 76a that are prepared by providing the conductive pastes 74, 75 and 76 having a given thickness around inlets of the through-holes 34a, 35a and 36a into which the sheet-metal screws 71, 72 and 73 are to be inserted. Providing the raised portions 74a, 75a and 76a can improve electrical connection between screw heads of the sheet-metal screws 71, 72 and 73 and the first, second and third ground patterns 34, 35 and 36 via the raised portions 74a, 75a and 76a, respectively.

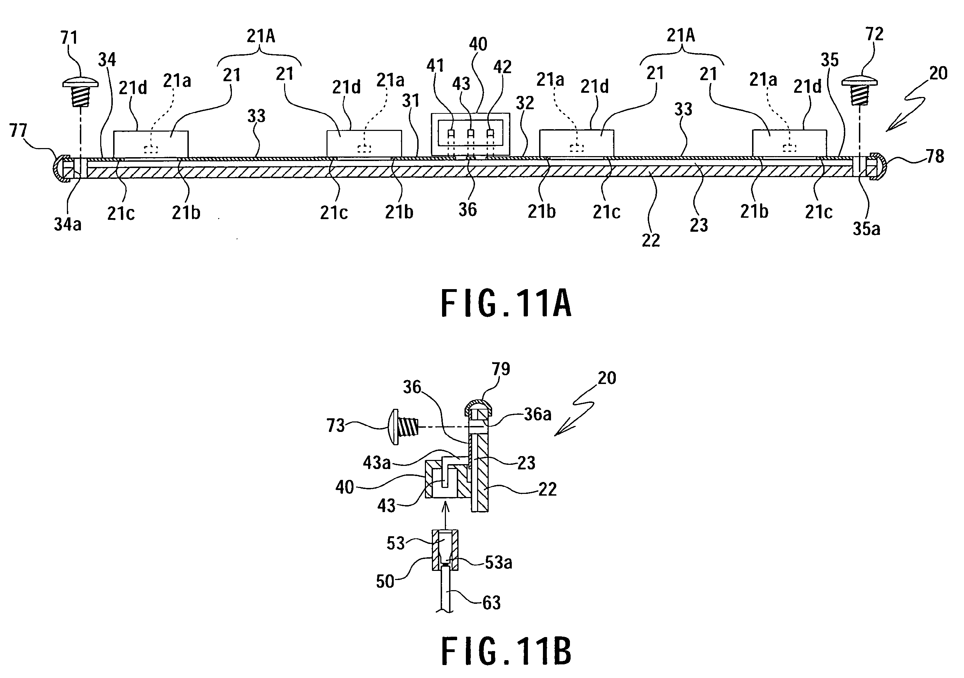

Figs. 11A and 11B are views showing the LED substrate 20 of the second modified embodiment, where the LED substrate 20 includes first, second and third conductive tapes 77, 78 and 79 that are made preferably of conductive aluminum tapes having adhesive faces. In the present modified embodiment, one end of the first conductive tape 77 is attached to the front surface of the first ground pattern 34, and the other end is attached to the back surface of the radiating plate 22 disposed under the first ground pattern 34 as shown in Fig. 11A, whereby the first ground pattern 34 and the radiating plate 22 are electrically connected via the first conductive tape 77.

In addition, in a similar manner, one end of the second conductive tape 78 is attached to the front surface of the second ground pattern 35, and the other end is attached to the back surface of the radiating plate 22 disposed under the second ground pattern 35 as shown in Fig. 11A, whereby the second ground pattern 35 and the radiating plate 22 are electrically connected via the second conductive tape 78.

In addition, in a similar manner, one end of the third conductive tape 79 is attached to the front surface of the third ground pattern 36, and the other end is attached to the back surface of the radiating plate 22 disposed under the third ground pattern 36 as shown in Fig. 11A, whereby the third ground pattern 36 and the radiating plate 22 are electrically connected via the third conductive tape 79.

Thus, this configuration allows not only electrical connection between the first ground pattern 34 and the radiating plate 22, electrical connection between the second ground pattern 35 and the radiating plate 22, and electrical connection between the third ground pattern 36 and the radiating plate 22 via the sheet-metal screws 71, 72 and 73, but also electrical connection between the first ground pattern 34 and the radiating plate 22, electrical connection between the second ground pattern 35 and the radiating plate 22, and electrical connection between the third ground pattern 36 and the radiating plate 22 via the conductive tapes 77, 78 and 79, which can further improve electrical connection between the first ground pattern 34 and the radiating plate 22, electrical connection between the second ground pattern 35 and the radiating plate 22, and electrical connection between the third ground pattern 36 and the radiating plate 22.

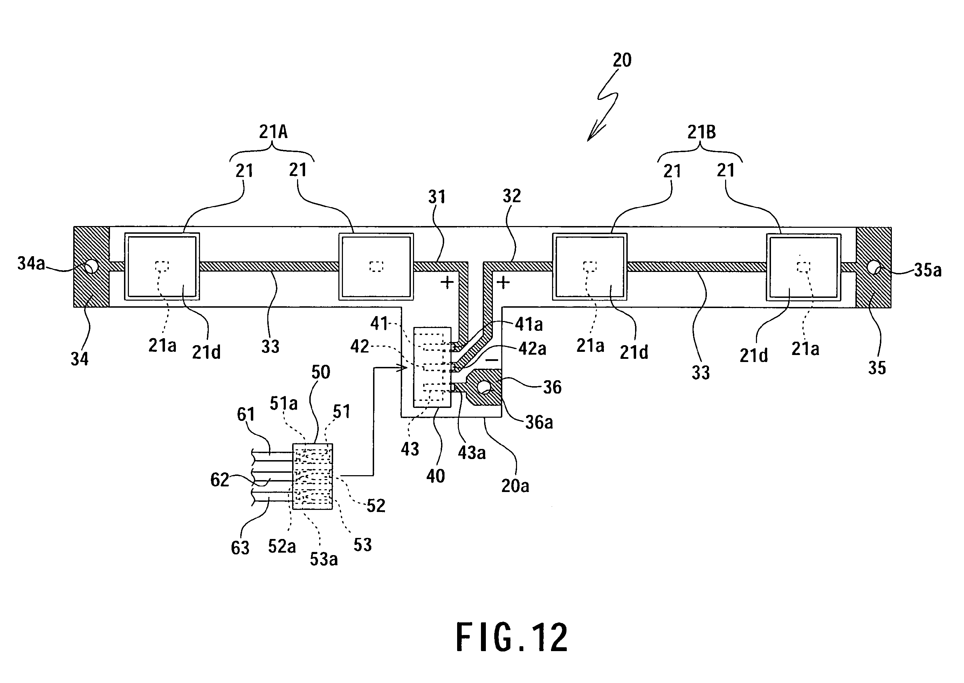

Fig. 12 is a view showing the LED substrate 20 of the third modified embodiment, where the LED substrate 20 includes a convex portion 20a that is protruded downward from the middle of the LED substrate 20. The substrate connector 40 and the third ground pattern 36 are disposed on the convex portion 20a. The LED substrates 20 of the third modified embodiment are capable of being attached to the fixing plate 115 standing on the convex portion 114c of the conventional backlight chassis 114 shown in Fig. 14 and explained above in the description of Background Art, and thus are used when the backlight chassis 114 has a height (space) enough to house the LED substrates in the standing position.

In the present modified embodiment, the substrate connector 40 is disposed such that a direction of insertion of the cable connector 50 into the connector 40 is made lateral (i.e., a direction parallel to the longitudinal direction of the LED substrate 20). The first light-source-side terminal 41 (positive terminal), the second light-source-side terminal (positive terminal) 42 and the ground-side terminal (negative terminal) 43 are disposed in this order from top down in a connector housing of the substrate connector 40. Meanwhile, the first light-source-side terminal (positive terminal) 51, the second light-source-side terminal (positive terminal) 52, and the ground-side terminal (negative terminal) 53 are disposed in this order from top down in a connector housing of the cable connector 50 so as to correspond to the substrate connector 40 to which the cable connector 50 is to be connected.

Because each LED substrate 20 described above of the present modified embodiment has the configuration that the first ground pattern 34 and the second ground pattern 35 are provided at the left and right ends of the LED substrate 20 while the third ground pattern 36 is provided in the middle of the LED substrate 20, and that the first ground pattern 34, the second ground pattern 35 and the third ground pattern 36 are electrically connected to one another via the metallic radiating plate 22, which is disposed thereunder while sandwiching therebetween the insulating layer 23, and via the sheet-metal screws 71, 72 and 73, the configuration can be used as a ground wire for the LEDs 21 that are connected in series.

Thus, downsizing (decreasing) in width of each LED substrate 20 by a width that is conventionally required in order to include the ground pattern 133 disposed linearly along the longitudinal direction of the LED substrate 120, can be achieved, and thus the height of the backlight chassis 14 (the height from the bottom plate 14a) can be reduced compared with a conventional backlight chassis as shown in Fig. 2, which can achieve a thinprofile of the backlight unit 4, and a thin profile of the liquid crystal display device 1.

In addition, the LED substrate 20 has the configuration that the substrate connector 40 arranged to supply power to the LEDs 21 is disposed in the middle of the LED substrate 20, which is different from the configuration of the LED substrate 120 explained above in the description of Background Art that the substrate connector 140 is disposed at either one of right and left ends of the LED substrate 120. Thus, the right and left ends of the LED substrate 20 can have the same shape.

Owing to the configuration of the LED substrates 20, distances P2 between the adjacent LEDs 21 of the adjacent LED substrates 20 can be made equal to distances P1 between the adjacent LEDs 21 of each LED substrate 20 as shown in Fig. 9. Thus, the three LED substrates 20 can be disposed such that the distances between the LEDs 21 are all uniform. In addition, the LED substrates 20 of one kind having this configuration can suffice when two, three or more than three LED substrates are disposed laterally.

The foregoing description of the preferred embodiments of the LED substrate, the backlight unit and the liquid crystal display device of the present invention has been presented for purposes of illustration and description with reference to the drawings. However, it is not intended to limit the present invention to the embodiments, and modifications and variations are possible as long as they do not deviate from the principles of the present invention. For example, described above in the preferred embodiments is the configuration that the LED substrates 20 are disposed along one side of the light guide plate 11; however, the present invention is not limited to this configuration. Configurations such that the LED substrates 20 are disposed along two or four opposed sides of the light guide plate 11 are preferably used.

## Claims

1. An LED substrate that comprises:
a radiating plate made from metal that has a rectangular shape long in a right/left direction;
an insulating layer disposed on an upper surface of the radiating plate;
a connector disposed in the middle on an upper surface of the insulating layer, and comprising a first light-source-side terminal, a second light-source-side terminal and a ground-side terminal;
a first LED group comprising a plurality of LEDs that are disposed to the left of the connector on the upper surface of the insulating layer linearly along a longitudinal direction of the radiating plate, and connected to each other in series;
a second LED group comprising a plurality of LEDs that are disposed to the right of the connector on the upper surface of the insulating layer linearly along the longitudinal direction of the radiating plate, and connected to each other in series;
a first light source pattern disposed in the middle on the upper surface of the insulating layer, and connected to the first LED from the right in the first LED group;
a second light source pattern disposed in the middle on the upper surface of the insulating layer, and connected to the first LED from the left in the second LED group;
a first ground pattern disposed at a left end on the upper surface of the insulating layer, and connected to the first LED from the left in the first LED group; and
a second ground pattern disposed at a right end on the upper surface of the insulating layer, and connected to the first LED from the right in the second LED group, wherein the LED substrate further comprises a third ground pattern disposed in the middle on the upper surface of the insulating layer,
wherein the first light source pattern is connected to the first light-source-side terminal of the connector,
wherein the second light source pattern is connected to the second light-source-side terminal of the connector,
wherein the third light source pattern is connected to the ground-side terminal of the connector,
wherein the first ground pattern is connected to the radiating plate via a first screw made from metal that is inserted in a first through-hole provided to the first ground pattern and the radiating plate,
wherein the second ground pattern is connected to the radiating plate via a second screw made from metal that is inserted in a second through-hole provided to the second ground pattern and the radiating plate, and
wherein the third ground pattern is connected to the radiating plate via a third screw made from metal that is inserted in a third through-hole provided to the third ground pattern and the radiating plate.

2. The LED substrate according to claim 1, wherein the metal from which the radiating plate is made comprises aluminum, and the first, second and third screws comprise sheet-metal screws.

3. The LED substrate according to claim 1 or 2, wherein conductive pastes are applied to inner surfaces of the first, second and third through-holes.

4. The LED substrate according to any one of claims 1 to 3, further comprising:
a first conductive tape, one end of which is attached to the first ground pattern, and the other end is attached to the radiating plate, wherein the first ground pattern and the radiating plate are connected via the first conductive tape;
a second conductive tape, one end of which is attached to the second ground pattern, and the other end is attached to the radiating plate, wherein the second ground pattern and the radiating plate are connected via the second conductive tape; and
a third conductive tape, one end of which is attached to the third ground pattern, and the other end is attached to the radiating plate, wherein the third ground pattern and the radiating plate are connected via the third conductive tape.

5. A backlight unit comprising:
a light guide plate having a plate shape;
an LED substrate disposed on a side surface of the light guide plate; and
a chassis made from metal and arranged to house the light guide plate and the LED substrate,
wherein the LED substrate comprises:
a radiating plate made from metal that has a rectangular shape long in a right/left direction;
an insulating layer disposed on an upper surface of the radiating plate;
a connector disposed in the middle on an upper surface of the insulating layer, and comprising a first light-source-side terminal, a second light-source-side terminal and a ground-side terminal;
a first LED group comprising a plurality of LEDs that are disposed to the left of the connector on the upper surface of the insulating layer linearly along a longitudinal direction of the radiating plate, and connected to each other in series;
a second LED group comprising a plurality of LEDs that are disposed to the right of the connector on the upper surface of the insulating layer linearly along the longitudinal direction of the radiating plate, and connected to each other in series;
a first light source pattern disposed in the middle on the upper surface of the insulating layer, and connected to the first LED from the right in the first LED group;
a second light source pattern disposed in the middle on the upper surface of the insulating layer, and connected to the first LED from the left in the second LED group;
a first ground pattern disposed at a left end on the upper surface of the insulating layer, and connected to the first LED from the left in the first LED group; and
a second ground pattern disposed at a right end on the upper surface of the insulating layer, and connected to the first LED from the right in the second LED group, wherein the LED substrate further comprises a third ground pattern disposed in the middle on the upper surface of the insulating layer,
wherein the first light source pattern is connected to the first light-source-side terminal of the connector,
wherein the second light source pattern is connected to the second light-source-side terminal of the connector,
wherein the third light source pattern is connected to the ground-side terminal of the connector,
wherein the first ground pattern is connected to the radiating plate via a first screw made from metal that is inserted in a first through-hole provided to the first ground pattern and the radiating plate,
wherein the second ground pattern is connected to the radiating plate via a second screw made from metal that is inserted in a second through-hole provided to the second ground pattern and the radiating plate, and
wherein the third ground pattern is connected to the radiating plate via a third screw made from metal that is inserted in a third through-hole provided to the third ground pattern and the radiating plate.

6. The backlight unit according to claim 5, wherein the metal from which the radiating plate is made comprises aluminum, and the first, second and third screws comprise sheet-metal screws.

7. The backlight unit according to claim 5 or 6, wherein conductive pastes are applied to inner surfaces of the first, second and third through-holes.

8. The backlight unit according to any one of claims 5 to 7, further comprising:
a first conductive tape, one end of which is attached to the first ground pattern, and the other end is attached to the radiating plate, wherein the first ground pattern and the radiating plate are connected via the first conductive tape;
a second conductive tape, one end of which is attached to the second ground pattern, and the other end is attached to the radiating plate, wherein the second ground pattern and the radiating plate are connected via the second conductive tape; and
a third conductive tape, one end of which is attached to the third ground pattern, and the other end is attached to the radiating plate, wherein the third ground pattern and the radiating plate are connected via the third conductive tape.

9. The backlight unit according to any one of claims 5 to 8, further comprising a fixing plate made from metal that is disposed to stand on the chassis,
wherein the LED substrate is fixed to the fixing plate by the first, second and third screws, and
wherein the radiating plate is electrically connected to the chassis via the fixing plate.

10. The backlight unit according to claim 9, further comprising a thermal conductive sheet disposed between the fixing plate and the radiating plate of the LED substrate.

11. The backlight unit according to claim 10, wherein the thermal conductive sheet possesses electrical conductivity.

12. A liquid crystal display device comprising:
a liquid crystal display panel; and
the backlight unit according to any one of claims 5 to 11 that is disposed behind the liquid crystal display panel.
